(19) Europäisches Patentamt
European Patent Office
Office européen des brevets

(11) **EP 2 695 967 B1**

## (12) FASCICULE DE BREVET EUROPEEN

(45) Date de publication et mention
de la délivrance du brevet:
**01.04.2015 Bulletin 2015/14**

(21) Numéro de dépôt: **13179922.3**

(22) Date de dépôt: **09.08.2013**

(51) Int Cl.:
*C23C 14/06* (2006.01)      *C23C 14/22* (2006.01)
*C23C 14/54* (2006.01)      *B05D 1/12* (2006.01)
*B82Y 40/00* (2011.01)

(54) **Procédé de synthèse d'un matériau composite nanostructuré et dispositif de mise en oeuvre associé.**

Syntheseverfahren eines Nanostruktur-Verbundmaterials, und entsprechende Vorrichtung für dessen Umsetzung

Process to synthetize a nanostructured composite material and associated dispositive.

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.08.2012 FR 1257770**

(43) Date de publication de la demande:
**12.02.2014 Bulletin 2014/07**

(73) Titulaire: **COMMISSARIAT A L'ENERGIE
ATOMIQUE ET AUX
ENERGIES ALTERNATIVES
75015 Paris (FR)**

(72) Inventeurs:
• **Sublemontier, Olivier**
 **92260 Fontenay aux Roses (FR)**
• **Kintz, Harold**
 **75013 Paris (FR)**
• **Leconte, Yann**
 **78470 St Remy-les-Chevreuse (FR)**

(74) Mandataire: **Reboussin, Yohann Mickaël Noël
Cabinet Orès
36, rue de St Pétersbourg
75008 Paris (FR)**

(56) Documents cités:
**WO-A1-01/55474**

• **HIHARA T ET AL: "Ferromagnetic, Transparent
and Conducting ITO-Fe-Cluster Composite
Films", IEEE TRANSACTIONS ON MAGNETICS,
IEEE SERVICE CENTER, NEW YORK, NY, US, vol.
41, no. 10, 1 octobre 2005 (2005-10-01), pages
3406-3408, XP011140863, ISSN: 0018-9464, DOI:
10.1109/TMAG.2005.855216**
• **WEGNER K ET AL: "Cluster beam deposition: a
tool for nanoscale science and technology",
JOURNAL OF PHYSICS D. APPLIED PHYSICS,
IOP PUBLISHING, BRISTOL, GB, vol. 39, no. 22,
21 novembre 2006 (2006-11-21), pages R439-
R459, XP002663013, ISSN: 0022-3727, DOI:
10.1088/0022-3727/39/22/R02 [extrait le
2006-11-03]**

EP 2 695 967 B1

**Description**

La présente invention se rapporte au domaine de la synthèse des matériaux composites nanostructurés.

Ces matériaux sont formés par des nanoparticules enrobées dans une matrice.

Par nanoparticules, on entend des particules, généralement solides, dont la taille est comprise entre 1 nm et quelques centaines de nanomètres. Par exemple, la taille des nanoparticules concernées peut être comprise entre 1 nm et 200nm.

Les matériaux composites nanostructurés présentent des propriétés singulièrement différentes de celles du même matériau à l'état massif, en particulier en fonction de la taille des nanoparticules enrobées dans la matrice.

Par exemple, il est généralement nécessaire de prévoir des nanoparticules de taille inférieure à 10nm pour modifier les propriétés électroniques et chimiques de ce matériau. Selon un autre exemple, il est généralement nécessaire d'avoir des nanoparticules de taille inférieure à 100nm pour modifier les propriétés mécaniques du matériau (ténacité, dureté, plasticité,...).

Le document WO01/55474 A1 décrit un procédé et un dispositif de synthèse d'un matériau composite nanostructuré comprenant des nanoparticules enrobées dans une matrice.

Il existe différentes techniques pour former de tels matériaux sur une surface cible.

L'une d'entre elles consiste à coupler deux systèmes distincts, l'un pour déposer les nanoparticules sur la surface cible, l'autre pour déposer la matrice sur cette surface cible, matrice dans laquelle les nanoparticules sont destinées à être enrobées.

Un dispositif de synthèse d'un matériau composite nanostructuré appartenant à cette technique est proposé dans l'article « Ferromagnetic, Transparent and Conducting ITO-Fe-Cluster Composite Films », D. L. Peng & al., IEEE Transactions on Magnetics, vol. 41, n°10, pp. 3406 à 3408, Octobre 2005.

Dans cet article, le dispositif comprend principalement trois régions: une première région formée par une chambre de pulvérisation, une deuxième région dans laquelle les nanoparticules croissent et dont la taille peut être contrôlée et une troisième région formée par une chambre de dépôt dans laquelle la synthèse du matériau est réalisée.

Les deux premières régions peuvent être assimilées à un premier système pour le dépôt des nanoparticules sur la surface cible.

La troisième région est assimilable à un deuxième système pour déposer la matrice, lequel est situé dans la chambre de synthèse.

Le couplage entre les deux systèmes s'effectue par l'intermédiaire d'un écorceur (« skimmer » selon la terminologie anglo-saxonne) par lequel les nanoparticules peuvent entrer dans la chambre de synthèse afin d'être déposées sur la surface cible. Cet écorceur permet de maintenir un différentiel de pression entre les deux systèmes qu'il sépare pour faciliter l'entrée des nanoparticules dans la chambre de synthèse.

Le premier système comprend des moyens pour générer un jet de gaz porteur entraînant les nanoparticules. Plus précisément, ces moyens comprennent une chambre de pulvérisation pour générer les nanoparticules et une source de gaz porteur, tel que l'Argon.

La chambre de pulvérisation utilise en l'occurrence une technique de condensation de vapeur générée par plasma (dite PGC pour Plasma-Gas-Condensation selon la terminologie anglo-saxonne).

La chambre de pulvérisation comprend un prolongement dans lequel les nanoparticules ainsi générées peuvent croître.

Le premier système comprend également une chambre intermédiaire, reliée à la chambre de pulvérisation par un écorceur. Une fois généré, le jet de gaz porteur entraînant les nanoparticules sort alors de la chambre de pulvérisation, traverse la chambre intermédiaire et entre finalement dans la chambre de synthèse, afin de permettre le dépôt des nanoparticules sur la surface cible. La chambre intermédiaire comporte ainsi un écorceur en entrée et un écorceur en sortie, afin de maintenir un grand différentiel de pression entre la chambre de pulvérisation et la chambre de synthèse.

A cet effet, la pression dans la chambre intermédiaire est inférieure à la pression dans la chambre de pulvérisation. La pression dans la chambre de synthèse est également inférieure à la pression dans la chambre intermédiaire.

Pour cette raison, ce dispositif ne peut pas mettre en oeuvre n'importe quel type de système pour le dépôt de la matrice. En effet, ce dispositif doit mettre en oeuvre une pulvérisation cathodique avec une cathode spéciale de type « Helicon », permettant un fonctionnement à très faible pression. En l'occurrence, la pression dans la chambre de synthèse est maintenue à 0,013Pa.

Le dispositif divulgué dans cet article présente plusieurs limitations.

Une première limitation est liée au fait que la pression doit diminuer depuis la chambre de pulvérisation jusqu'à la chambre de synthèse pour que le jet de gaz porteur puisse entraîner les nanoparticules jusqu'à la surface cible située dans la chambre de synthèse.

Ceci implique que la pression régnant dans la chambre de synthèse est très faible.

Cette très faible pression dans la chambre de synthèse est à l'origine d'une deuxième limitation. En effet, l'emploi d'une pulvérisation cathodique spécifique, de type « Helicon », pour pouvoir déposer la matrice à très basse pression dans la chambre de synthèse est obligatoire.

Une troisième limitation est liée à la source de nanoparticules, laquelle fonctionne par condensation d'une vapeur générée par plasma. En effet, cette technique n'est envisageable que pour des nanoparticules métalliques. Dans cet article, les nanoparticules sont en fer.

Une quatrième limitation est liée à la structure du matériau composite nanostructuré finalement synthétisé. En effet, cet article propose des structures séquentielles où se succèdent des zones contenant des nanoparticules et des zones n'en contenant pas. Il n'est donc pas envisagé de synthétiser des matériaux composites nanostructurés dans lesquels les nanoparticules sont distribuées de façon homogène dans la matrice.

Un objectif de l'invention est de pallier l'une au moins des limitations mentionnées ci-dessus.

En particulier, un objectif de l'invention est de proposer un choix élargi de dispositif de dépôt de la matrice enrobant les nanoparticules.

En particulier, un autre objectif de l'invention est de proposer un procédé de synthèse d'un matériau composite nanostructuré, avec lequel il est possible de synthétiser un matériau pour lequel le choix dans la nature chimique des nanoparticules et/ou dans la nature chimique de la matrice sont élargis.

En particulier également, un objectif de l'invention est encore de proposer un procédé de synthèse d'un matériau composite nanostructuré, avec lequel il est envisageable de synthétiser des structures variées dans l'agencement des nanoparticules dans la matrice, notamment des structures plus homogènes.

L'invention vise également à proposer un dispositif de mise en oeuvre du procédé selon l'invention.

Pour atteindre l'un au moins de ces objectifs, l'invention propose un procédé de synthèse d'un matériau composite nanostructuré comprenant des nanoparticules enrobées dans une matrice, tel que décrit dans la revendication 1.

Le procédé pourra prévoir d'autres caractéristiques techniques, prises seules ou en combinaison :

- on ajuste la pression dans la chambre de synthèse par l'introduction d'un gaz supplémentaire dans cette chambre de synthèse,
- on ajuste la pression dans la chambre de synthèse par l'introduction d'un gaz neutre ou d'un mélange de gaz neutres ;
- on introduit un ou plusieurs gaz précurseurs dans la chambre de synthèse ;
- la pression dans la chambre de détente est comprise entre 0,01 Pa et 10Pa ;
- la pression dans la chambre de synthèse est comprise entre 0,001Pa et 10Pa, de préférence entre 0,1 Pa et 1 Pa ;
- l'étape (a) est effectuée par pulvérisation cathodique, par dépôt physique en phase vapeur ou par dépôt chimique en phase vapeur, éventuellement assisté par plasma ;
- on chauffe la surface cible ;
- on dépose les nanoparticules et la matrice sur la surface cible en même temps ou séquentiellement ;
- l'étape (c) consiste à ajuster la constante C à une valeur inférieure ou égale à 1,5.

A cet effet, l'invention propose également un dispositif de mise en oeuvre du procédé selon l'invention, caractérisé en ce qu'il comprend :

- une chambre de synthèse dudit matériau comportant un système de dépôt de la matrice sur une surface cible ;
- un système pour générer un jet de nanoparticules dans un gaz porteur comportant une chambre de détente munie d'un orifice de sortie des nanoparticules, séparant la chambre de détente de la chambre de synthèse ;
- des moyens pour régler la distance L entre l'orifice de sortie de la chambre de détente et la surface cible.

Ce dispositif pourra prévoir d'autres caractéristiques techniques, prises seules ou en combinaison :

- la chambre de synthèse comprend au moins un dispositif pour introduire un gaz, tel qu'un gaz neutre, dans cette chambre ;
- le système pour générer un jet moléculaire de nanoparticules dans un gaz porteur comprend également :

   o un réservoir comportant un mélange de nanoparticules et d'un gaz porteur ;
   ◦ une tuyère ou une lentille aérodynamique située entre le réservoir et la chambre de détente ;
   ◦ un moyen de pompage du fluide présent dans la chambre de détente.

- la distance entre la tuyère ou la lentille aérodynamique d'une part, et l'orifice de sortie de la chambre de détente d'autre part, est comprise entre 1mm et 60mm, de préférence entre 5mm et 30mm ;
- la distance entre la tuyère ou la lentille aérodynamique d'une part, et l'orifice de sortie de la chambre de détente d'autre part, est réglable ;
- l'orifice de sortie de la chambre de détente est un diaphragme destiné à limiter l'angle solide du jet de gaz porteur entraînant les nanoparticules, ce diaphragme étant par exemple un écorceur circulaire de section conique et dont le diamètre situé à la pointe du cône est compris entre 0,1mm et 2mm.

D'autres caractéristiques, buts et avantages de l'invention seront énoncés dans la description détaillée ci-après faite en référence aux figures qui représentent, respectivement :

- la figure 1 est un schéma d'un dispositif de synthèse d'un matériau composite nanostructuré selon l'invention;
- la figure 2 est un tableau représentant les valeurs d'un facteur dépendant de la vitesse $V_g$ moyenne des atomes/molécules du gaz dans la chambre de synthèse sur la vitesse $V_p$ moyenne des nanoparticules dans le jet de gaz porteur ;

- la figure 3 est un schéma d'une variante de réalisation du dispositif représenté sur la figure 1 ;
- la figure 4 représente l'évolution de la vitesse de dépôt de nanoparticules sur une surface cible, avec le dispositif représenté sur la figure 1, en fonction de la densité atomique ou moléculaire du gaz présent dans la chambre de synthèse, donc de la pression.

Le dispositif 100 comprend une chambre de synthèse 3 du matériau composite nanostructuré. Ce matériau composite nanostructuré est réalisé à partir de nanoparticules enrobées dans une matrice.

Cette chambre de synthèse 3 comprend un système 13 de dépôt de la matrice sur une surface cible 15. Ce système de dépôt 13 de la matrice génère un flux d'atomes ou de molécules 14 destiné à être déposé sur la surface cible 15.

Elle comprend également un moyen de pompage 11, par exemple réalisé avec une ou plusieurs pompes turbomoléculaires, permettant d'atteindre une pression comprise entre 0,001Pa et 10Pa dans la chambre de synthèse 3.

La chambre de synthèse 3 comprend également un moyen 12, formé d'une ou plusieurs vannes de précision ou d'un ou plusieurs débitmètres massiques, permettant l'entrée contrôlée dans la chambre de synthèse 3 d'un gaz supplémentaire.

Ce gaz supplémentaire peut être un gaz neutre tel que l'argon, l'azote ou un mélange de gaz neutres dans le cas d'un dépôt physique en phase vapeur (« PVD » pour « Physical Vapor Deposition » selon la terminologie anglo-saxonne). Il peut s'agir par exemple de pulvérisation cathodique, de plasma à arc, de plasma micro-onde ou d'évaporation. L'introduction de ce gaz dans la chambre de synthèse 3 permet d'ajuster la pression dans cette chambre.

Ce gaz supplémentaire peut aussi être formé par un ou plusieurs gaz précurseurs dans le cas où le dépôt du matériau de la matrice est réalisé par dépôt chimique en phase vapeur (« CVD » pour « Chemical Vapor Deposition » selon la terminologie anglo-saxonne), dépôt chimique en phase vapeur assisté par plasma (« PECVD » pour « Plasma Enhanced Chemical Vapor Deposition » selon la terminologie anglo-saxonne).

En utilisant une technique de dépôt de la matrice tout à fait classique, telle que la pulvérisation cathodique, la CVD ou la PECVD, la pression dans la chambre de synthèse 3 doit alors être suffisamment élevée pour permettre le fonctionnement du système de dépôt 13.

Par exemple, dans le cas d'un système de pulvérisation cathodique 13 classique, la pression minimum à atteindre dans la chambre de synthèse est de l'ordre de 0,1 Pa. La pression dans la chambre de synthèse 3 est ainsi comprise entre 0,1 Pa et 10Pa, avantageusement entre 0,1 Pa et 1 Pa. Il convient de noter que des pressions trop élevées dans la chambre de synthèse limitent la taille des nanoparticules qu'on peut déposer.

Selon un autre exemple, le système de pulvérisation cathodique est de type pulvérisation magnétron impulsionelle haute puissance (HIPIMS pour « High Power Magnetron Sputtering » selon la terminologie anglo-saxonne). Dans ce cas, la pression minimum à atteindre dans la chambre de synthèse 3 est de l'ordre de 0,05Pa. La pression dans la chambre de synthèse 3 est ainsi comprise entre 0,05Pa et 10Pa, avantageusement entre 0,05Pa et 1Pa. Cette technique permet d'augmenter significativement les vitesses de dépôt.

Comme on peut le constater, le dispositif 100 peut mettre en oeuvre des systèmes de dépôt 13 capables de fonctionner à des pressions pouvant aller jusqu'à 10Pa. Cette dernière pression est largement plus élevée que la pression de fonctionnement dans la chambre de synthèse mettant en oeuvre une pulvérisation cathodique avec une cathode de type « Helicon » dans l'article de D.L. Peng & al. Pour autant, le dispositif 100 peut également fonctionner à des pressions comparables aux pressions de fonctionnement nécessaires à la mise en oeuvre d'une pulvérisation cathodique de type « Helicon ».

Cet avantage peut cependant être obtenu sous certaines conditions nécessitant, au préalable, la description complète du dispositif 100.

Le dispositif 100 comprend également un système 1, 4, 5, 9 pour générer un jet 6a de gaz porteur entrainant les nanoparticules.

Le système 1, 4, 5, 9 comprend un réservoir 4 qui contient un mélange de gaz porteur et de nanoparticules en suspension gazeuse. La pression et la température du gaz ainsi que la concentration de nanoparticules dans ce gaz sont ajustables.

Le réservoir 4 peut être un réacteur de synthèse fonctionnant par exemple par pyrolyse laser, ablation laser, évaporation sous vide, combustion ou être un générateur de nanoparticules par plasma. Il peut également s'agir d'un générateur d'aérosols nanométriques formés à partir d'une suspension de nanoparticules dans un liquide élaborée à l'avance ou à partir d'une poudre nanométrique sèche. Ces techniques ne présentent pas les limitations de la technique PGC quant aux matériaux utilisables pour les nanoparticules.

Ce système 1, 4, 5, 9 comprend également une chambre de détente 1 dans laquelle le gaz porteur contenant les nanoparticules est introduit à partir du réservoir 4. La pression dans la chambre de détente 1 est inférieure à la pression du réservoir 4.

Le passage du réservoir 4 à la chambre de détente 1 s'effectue par l'intermédiaire d'un moyen 5 pouvant être une tuyère ou une lentille aérodynamique.

Dans le cas d'une tuyère, il peut s'agir d'une tuyère de Laval, d'une tuyère conique, d'une tuyère sonique ou de tout autre orifice. Son diamètre peut être compris entre 0,1mm et 2mm. Son orifice peut être de forme circulaire, oblongue ou rectangulaire.

Dans le cas d'une lentille aérodynamique, ses caractéristiques peuvent être prévues pour obtenir un jet convergent, colinéaire ou divergent, en fonction de sa géométrie, des pressions à son entrée et à sa sortie, pour un diamètre aérodynamique équivalent donné de nanoparticules transportées par le gaz porteur, et suivant les caractéristiques du matériau nanostructuré recherchées.

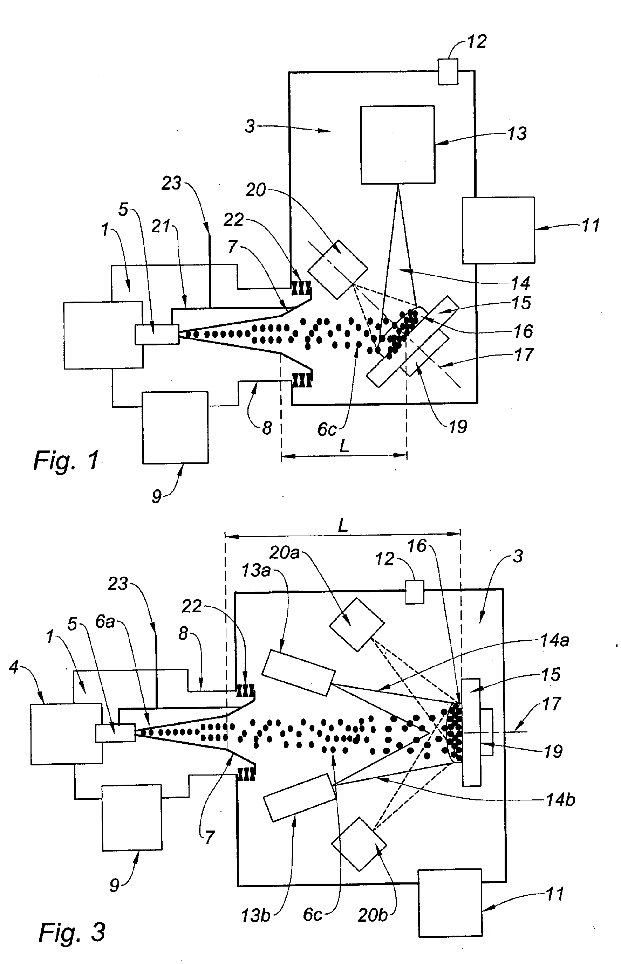

Dans le cas du dispositif 100 représenté sur la figure 1, le moyen 5 utilisé est une lentille aérodynamique divergente.

Le système 1, 4, 5, 9 comprend également un moyen de pompage 9, destiné à faire régner un vide poussé dans la chambre de détente 1. Le moyen de pompage 9 peut être formé d'une ou de plusieurs pompes turbomoléculaires ou d'une pompe dite « roots » multiétagée.

Une pression comprise entre 0,01Pa et 10Pa est ainsi maintenue dans la chambre de détente 1. De préférence, cette pression est comprise entre 0,01Pa et 0,2Pa pour faciliter la génération d'un jet supersonique sans avoir une pression excessivement élevée dans le réservoir 4.

Dans le cadre de l'invention, le couplage entre le système pour générer le jet 6a de gaz porteur entraînant les nanoparticules et la chambre de synthèse 3 du matériau composite nanostructuré est réalisé par l'intermédiaire d'un orifice 7 séparant la chambre de détente 1 de la chambre de synthèse 3. Il n'y a donc aucune chambre intermédiaire ou tampon comme dans l'art antérieur, comme cela est d'ailleurs visible sur les figures 1 et 3 annexées.

Le jet 6a de gaz porteur contenant les nanoparticules est ainsi généré entre le réservoir 4 et la chambre de détente 1 à l'aide d'un différentiel de pression volontairement maintenu entre le réservoir 4 et la chambre de détente 1.

Il traverse ensuite l'orifice de sortie 7 de la chambre de détente 1.

Avantageusement, cet orifice de sortie 7 est un diaphragme qui présente une double fonction de séparation des chambres de détente 1 et de synthèse 3 et de limitation de l'angle solide du jet.

Un tel diaphragme 7 peut être circulaire ou rectangulaire. Il peut être de section plate ou conique.

Avantageusement, le diaphragme 7 est un écorceur. Cet écorceur peut être circulaire de section conique et dont le diamètre situé à la pointe du cône est compris entre 0,1mm et 2mm.

La distance minimum entre la tuyère ou la lentille aérodynamique 5 et l'orifice de sortie 7 de la chambre de dépôt 1 peut être comprise entre 1 mm et 60mm. Elle est préférentiellement choisie entre 5mm et 30mm. Elle peut être rendue réglable de l'extérieur en fonction des conditions de détente du jet par des moyens de réglage manuels ou motorisés 21, 22, 23 qui sont décrits ultérieurement.

Il convient de noter que le jet de gaz porteur entraînant les nanoparticules qui se propage dans la chambre de détente 1 peut être un jet supersonique en cours de formation ou bien un jet effusif.

En entrant dans une chambre de synthèse où règne une pression élevée, telles que celles présentées précédemment pour la chambre de synthèse 3 conforme à l'invention, les données connues à ce jour indiquaient que le jet était dégradé après son entrée dans la chambre de synthèse si bien que ni le gaz porteur, ni les nanoparticules entraînées par ce gaz ne pouvaient atteindre la surface cible 15.

C'est d'ailleurs pour cette raison que le dispositif de Peng & al. fonctionne à faible pression (0,013Pa dans ce cas) avec un système de dépôt de la matrice de type « Helicon ». Par ce biais, le jet de gaz porteur peut atteindre la surface cible avec les nanoparticules sans être dégradé.

Dans le cadre de l'invention, les inventeurs se sont en revanche aperçus que, sous certaines conditions, les nanoparticules continuaient leur chemin en direction de la surface cible 15 et ce, malgré d'une part, la dégradation du jet de gaz porteur en entrée de la chambre de synthèse et d'autre part, un niveau de pression élevé (pression entre 0,05Pa et 10Pa) dans cette chambre de synthèse 3.

La pression régnant dans la chambre de synthèse 3 peut ainsi être élevée et par suite, supérieure voire largement supérieure à la pression régnant dans la chambre de détente 1, lorsqu'un système de dépôt 13 classique est employé. Pour autant, l'invention n'interdit pas que la pression dans la chambre de synthèse 3 soit inférieure à la pression régnant dans la chambre intermédiaire avec d'autres dispositifs de dépôt 13 de la matrice.

Nous allons maintenant préciser les conditions dans lesquelles l'invention rend possible un choix élargi de dispositifs de dépôt de la matrice enrobant les nanoparticules.

Les inventeurs ont en effet pu mettre en évidence l'influence de différents paramètres physiques permettant d'obtenir un dépôt de bonne qualité sur la surface cible 15.

Ces paramètres sont les suivants.

L (m) : distance moyenne entre l'orifice de sortie 7 et la surface cible 15 ;
$N_g$ (m$^{-3}$) : densité atomique/moléculaire du gaz présent dans la chambre de synthèse pour le dépôt de la matrice ;
Mg (g.mol$^{-1}$) : la masse molaire du gaz présent dans la chambre de synthèse pour le dépôt de la matrice ;
n (sans dimension) : le nombre moyen d'atomes/molécules par nanoparticule ou par agglomérat de nanoparticules ;
$M_p$ (g.mol$^{-1}$) : la masse molaire des atomes/molécules composant les nanoparticules ;
σ (m$^2$) : la section efficace géométrique moyenne

d'une nanoparticule ($\sigma_p$) ou de l'agglomérat de nanoparticules ($\sigma_a$); et

$F_{ao}$ ($\infty$,$V_g/V_p$) (sans dimension) : un facteur dépendant du rapport (sans dimension) entre la vitesse $V_g$ moyenne des atomes/molécules présents dans la chambre de synthèse sur la vitesse $V_p$ moyenne des nanoparticules entraînées dans le jet de gaz porteur.

La distance L est précisée sur les figures annexées. Il s'agit de la distance parcourue par le jet de nanoparticules dans la chambre de synthèse 3.

Cette distance L est avantageusement réglable.

A cet effet, on peut prévoir un système à vis 21 monté sur une glissière afin de modifier la distance entre le moyen 5 et l'orifice de sortie 7 de la chambre de détente 1. Un soufflet 22, disposé à l'interface entre les chambres 1 et 3 rend possible cette variation de distance, tout en maintenant une étanchéité entre ces deux chambres 1, 3. Par ce biais, la distance entre le moyen 5 et la surface cible 15 est maintenue constante, si bien que le réglage de la distance entre le moyen 5 et l'orifice de sortie de la chambre de détente 1 permet également de régler la distance entre cet orifice de sortie 7 et la surface cible 15. De préférence, un système mécanique 23 externe au dispositif de synthèse 100 est employé pour agir sur le système à vis et glissière 21.

Ce système de réglage 21, 22, 23 est largement répandu dans le domaine technique considéré. Il était cependant utilisé à ce jour afin de régler les conditions de détente du jet dans la chambre de détente 1, lorsqu'une chambre tampon est prévue entre la chambre de détente et la chambre de synthèse.

Selon une variante à ce système de réglage (non représentée), il est envisageable d'intercaler des entretoises entre l'orifice de sortie 7 de la chambre de détente 1 et la chambre de synthèse 3 pour régler la distance L entre cet orifice 7 et la surface cible 15. Dans ce cas, il est envisageable de maintenir la distance entre le moyen 5 et l'orifice de sortie 7 de la chambre de détente 1 constante.

Le gaz présent dans la chambre de synthèse 3 est avantageusement introduit par le dispositif 12. La nature du gaz dans la chambre de synthèse étant connue, sa masse molaire $M_g$ est déduite aisément.

De plus, la densité Ng de ce gaz dans la chambre de synthèse 3 est facilement déterminable, par exemple par des moyens de mesure de la pression dans la chambre de synthèse (non représentés).

En l'absence d'agglomérat, le nombre n = np moyen d'atomes/molécules par nanoparticule est par exemple déterminé par calcul. En effet, en connaissant la densité du matériau dp composant les nanoparticules, la masse molaire $M_p$ et le rayon $r_p$, le nombre np peut être déduit de la relation suivante :

$$n_p = \frac{4}{3}\pi \dot{r_p}^3 \cdot d_p \cdot \frac{N_A}{M_p} \qquad (R1)$$

où:

$r_p$ est le rayon moyen de la nanoparticule considérée (m) ;

dp est la densité des atomes/molécules composant les nanoparticules (g.m$^{-3}$) ;

Mp est la masse molaire des atomes/molécules composant les nanoparticules (g.mol$^{-1}$) ; et

$N_A$ est le nombre d'Avogadro (mol$^{-1}$).

Pour déterminer le rayon moyen $r_p$ de la nanoparticule, on utilise généralement la microscopie électronique à transmission (TEM pour « Transmission Electron Microscopy » selon la terminologie anglo-saxonne). De manière connue, la TEM permet de prendre des clichés sur une centaine de nanoparticules. L'analyse statistique des clichés permet alors de déterminer le rayon moyen d'une nanoparticule ($r_p$). De plus, la résolution obtenue avec cette technique est de l'ordre du dixième de nanomètre.

Une autre méthode pour déterminer la valeur de $r_p$, notamment utilisée lorsque les nanoparticules sont en suspension dans un solvant, est la diffusion de lumière dynamique (DLS pour « Dynamic Light Scattering » selon la terminologie anglo-saxonne). Cependant, dans la mesure où cette méthode ne permet pas de déterminer si les nanoparticules sont dans un état aggloméré ou pas, il convient généralement d'effectuer également une mesure par TEM.

La nature des nanoparticules étant connue, la masse molaire Mp des atomes/molécules constituant les nanoparticules, ainsi que leur densité dp est déduite aisément.

Une méthode largement répandue pour déterminer si les nanoparticules sont agglomérées ou non est également la TEM, par l'analyse statistique des clichés.

Cela permet donc de savoir s'il convient de prendre en compte le paramètre $\sigma_p$ ou $\sigma_a$ et ce qu'il convient de prendre en compte pour le paramètre n.

En l'absence d'agglomération, la section efficace géométrique moyenne d'une nanoparticule ($\sigma_p$ ; pas d'agglomération), est donnée par :

$$\sigma = \sigma_p = \pi \cdot r_p^2 \qquad (R2)$$

où : $r_p$ est le rayon moyen de la nanoparticule considérée.

Et le paramètre n = $n_p$, comme précisé à la relation (R1), par exemple.

Dans le cas de nanoparticules agglomérées, on a alors

$$\sigma = \sigma_a$$

où $\sigma_a = \dfrac{n_{pp}^{\frac{1}{\alpha}}}{k_a} . \sigma_p$ (R3).

Pour l'application de cette relation R3, la quantité $\sigma_p$ a déjà été définie précédemment.

Par ailleurs, le coefficient $k_a$ vaut 1,16 et le coefficient $\alpha$ vaut 1,1.

Le nombre $n_{pp}$ de nanoparticules dans l'agglomérat est généralement déterminé par TEM, même si d'autres techniques connues de l'homme du métier peuvent être envisagées.

La connaissance du nombre $n_{pp}$ permet par ailleurs d'obtenir le nombre n nombre moyen d'atomes/molécules par agglomérat de nanoparticules, car n = $n_{pp}*n_p$ où np est obtenu par la relation (R1).L'article de de Koliu & al., « Fractal and Projected Structure Properties of Soot Aggregates », Combustion and Flame 100 :621-633 (1995), détaille les éléments conduisant à la relation entre $\sigma_a$ et $\sigma_p$. En particulier, il convient de noter que des clichés d'agglomérats obtenu par TEM sont proposés dans cet article.

Enfin, le facteur $F_{ao}$ ($\infty,V_g/V_p$) est déterminé à partir des données fournies dans l'article de Berkling & al., « Effektive Stopquerschnitte bei Streuversuchen », Zeitschrift für Physik, 166, pp. 406-428 (1966).

En particulier, cet article fournit un tableau mentionnant la valeur de ce facteur en fonction du rapport $V_g/V_p$.

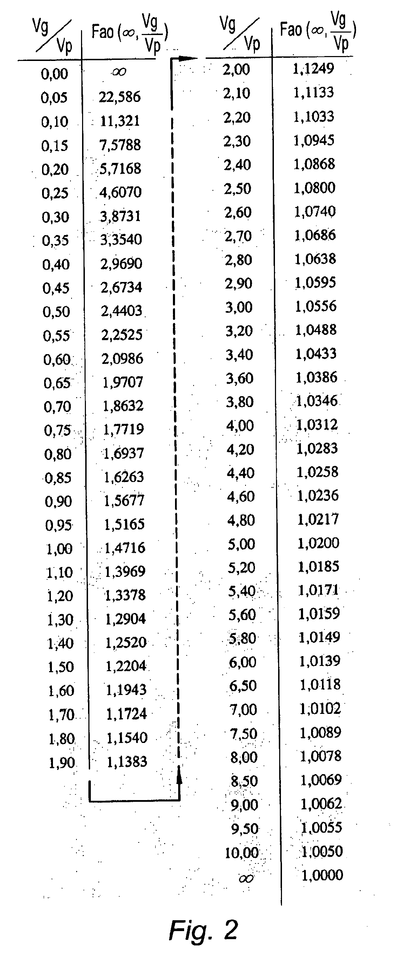

Ce tableau est reproduit sur la figure 2 annexée.

Il existe plusieurs techniques pour déterminer la vitesse moyenne $V_p$ des nanoparticules dans le jet de gaz porteur.

Par exemple, il est possible d'employer la méthode de la spectrométrie de masse à temps de vol.

Selon un autre exemple, il est possible d'utiliser la méthode des hacheurs à fentes, couplée à la spectrométrie de masse.

Selon un autre exemple, il est encore possible d'utiliser des méthodes optiques de diffusion de la lumière au passage des nanoparticules. Le temps mesuré entre deux diffusions permet d'en déduire la vitesse. Il convient cependant de noter que cette dernière méthode n'est applicable qu'à des nanoparticules suffisamment grosses (typiquement au moins 80 nm).

La vitesse moyenne $V_g$ des atomes/molécules formant le gaz présent dans la chambre de synthèse est déterminée par les lois de la théorie cinétique des gaz, à savoir :

$$\frac{1}{2} . m_g . V_g^2 = \frac{3}{2} . k . T \qquad (R4)$$

où :

$m_g$ est la masse d'un atome ou d'une molécule du gaz présent dans la chambre de synthèse (kg)

k la constante de Boltzmann (J.kg$^{-1}$); et

T la température absolue du gaz présent dans la chambre de synthèse (K).

Outre les paramètres identifiés par les inventeurs, ces derniers se sont aperçus que ces paramètres devaient répondre à une relation particulière pour obtenir un dépôt de bonne qualité sur la surface cible.

En effet, les inventeurs ont défini une constante C (sans dimension) par la relation :

$$C = L . N_g . \frac{M_g}{n.M_p} . \sigma . F_{ao} \left( \infty, \frac{V_g}{V_p} \right) \qquad (R5)$$

pour laquelle C doit être inférieur ou égal à une valeur maximale $C_{max} = 2$.

Il convient de noter que les paramètres L, $N_g$, $M_g$, n, Mp, $\sigma$ et $F_{ao}$ ($\infty,V_g/V_p$) définissant la constante C ont déjà été identifiés comme intervenant dans la variation de vitesse relative $\Delta V/V$ d'un agrégat d'atomes d'argon entre l'entrée et la sortie d'une chambre sous pression, ci-après dite chambre finale, de longueur L entre son entrée et sa sortie.

On pourra par exemple se référer à l'article de Cuvellier & al., « A simple method to determine the mean cluster size in a molecular beam », Z. Phys. D - Atoms, Molecules and Clusters 21, 265-269 (1991).

Ces paramètres sont donc représentatifs d'une réalité physique liée notamment à la variation de vitesse des nanoparticules dans une chambre dans laquelle est maintenue une pression donnée.

Plus précisément, en comparant la relation (R5) à la relation (6) proposée dans l'article de Cuvellier & al. (1991), on note que c'est la constante C qui est homogène (bien que différente) à une variation de vitesse relative telle que définie dans cet article.

Dans cet article, il est prévu un système pour générer des nanoparticules (ou agrégats) à partir d'un gaz par détente dans un jet supersonique. Ces particules sont entrainées par la part non agrégée des atomes (Argon en l'occurrence) de gaz qui devient un gaz porteur. Un écorceur sépare la chambre de détente d'une chambre intermédiaire. La formation définitive du faisceau supersonique de gaz a lieu après le passage de l'écorceur dans cette chambre intermédiaire grâce à un différentiel de pression maintenu entre la chambre de détente et la chambre intermédiaire. La pression dans la chambre intermédiaire est plus basse d'au moins un facteur 10 que dans la chambre tampon. C'est la condition nécessaire à l'établissement d'un jet supersonique de gaz de qualité. Une chambre finale, reliée à la chambre intermédiaire et maintenue à une pression réglable, est traversée par le jet supersonique entrainant les nanoparticules. La sortie de cette chambre finale est munie de moyens pour déterminer la vitesse des nanoparticules.

Le dispositif proposé dans cet article vise simplement à déterminer la taille moyenne d'agrégats d'argon, à l'aide d'une mesure de variation de leur vitesse en sortie de la chambre finale. Il ne s'intéresse donc pas à la synthèse d'un matériau composite nanostructuré comprenant des nanoparticules enrobées dans une matrice.

De plus, la formation du jet supersonique est effectuée de manière classique, à savoir avec une chambre intermédiaire et ce, contrairement à ce qui est proposé dans l'invention.

Enfin, les pressions dans la chambre finale sont très faibles, a priori pour assurer un gradient de pression entre la génération du jet et la chambre finale (comme dans Peng & al.), d'où des pressions qui ne dépassent pas $3*10^{-4}$ mbar (cf. figure 2 de cet article) à savoir environ 0,03Pa, dans cette chambre finale. A ces niveaux de pression, il serait impossible de mettre en oeuvre un système 13 pour le dépôt d'une matrice par pulvérisation cathodique (classique = 0,1Pa minimum ; HIPIMS = 0,05Pa minimum), comme cela est proposé dans le cadre de l'invention.

Un intérêt de la constante C réside dans le fait qu'elle permet de définir une limite $C_{max}$ aisément identifiable au-dessus de laquelle le dépôt n'est plus de bonne qualité. Ainsi, au-delà de cette valeur $C_{max}$, un dépôt de bonne qualité sur la surface cible 15 n'est pas assuré.

La constante C pourra notamment être inférieure ou égale à 1,9 ; 1,8 ; 1,7 ; 1,6 ; ou de préférence inférieure ou égale à 1,5, valeur en dessous de laquelle le dépôt est d'excellente qualité. Plus généralement, il est particulièrement avantageux de définir une constante C la plus faible possible (la valeur nulle étant par définition exclue, car elle se traduit physiquement par une absence de fonctionnement du dispositif de synthèse).

Le dispositif 100 selon l'invention prévoit donc des systèmes de dépôt différents sur une même surface cible 15. Un premier système de dépôt permet de déposer des nanoparticules sur la surface cible, l'autre permettant de déposer la matrice dans laquelle les nanoparticules seront enrobées pour former le matériau composite nanostructuré 16.

Les natures chimiques des nanoparticules d'une part et de la matrice d'autre part peuvent être choisies indépendamment l'une de l'autre. Le dispositif 100 offre ainsi une grande souplesse dans le choix des matériaux utilisables pour les nanoparticules d'une part et la matrice d'autre part. Ceci est principalement lié au fait que la génération du jet de gaz porteur entraînant les nanoparticules et le dépôt de la matrice dans la chambre de synthèse sont indépendants l'un de l'autre.

La chambre de synthèse 3 peut utiliser des techniques de dépôt classiques facilitant le dépôt de tous types de matériaux pour la matrice, techniques telles que la pulvérisation cathodique, la PVD ou la PECVD, en particulier la PECVD dite « basse pression ». Par PECVD basse pression, il faut ici comprendre que les pressions envisagées sont typiquement comprises entre 0,1 Pa et 1 Pa, les techniques PECVD dans leur généralité pouvant être employées jusqu'à des pressions de 1000Pa.

La surface cible 15 peut être animée d'un mouvement de rotation par des moyens de déplacement 19, manuels ou motorisés.

Ces moyens 19 peuvent permettre des mouvements de translation et de rotation de la surface cible 15 suivant tous les axes et dans toutes les directions.

Cela permet l'obtention de dépôts volontairement inhomogènes. Par exemple, il est possible, sur certaines zones de la surface cible 15, de composer des motifs de plus haute densité en nanoparticules.

L'inhomogénéité du dépôt de nanoparticules peut également être facilitée par le choix du jet, légèrement divergent, colinéaire ou convergent selon le cas. La forme de ce jet peut par exemple être déterminée par le choix de la lentille aérodynamique 5.

Ces moyens permettent plus simplement un déplacement en rotation de la surface cible 15 autour de son axe principal 17.

Cela permet des dépôts plus homogènes.

Par ailleurs, la liberté de positionnement de la surface cible offerte par les moyens 19, lesquels peuvent être disposés sur la face de ladite surface cible 15 opposée à la face sur laquelle le dépôt est effectué, permet de réaliser un co-dépôt des nanoparticules avec la matrice ou, au contraire, un dépôt séquentiel des nanoparticules et de la matrice.

Par exemple, la configuration représentée sur la figure 1 permet un co-dépôt de la matrice et des nanoparticules, dit angulaire.

Selon cette configuration dite angulaire, l'axe 17 normal à la surface cible 15 est placé entre l'axe de propagation du jet de nanoparticules et l'axe de propagation du faisceau 14 d'atomes ou de molécules générés par le système de dépôt 13 de la matrice.

Dans la configuration particulière présentée sur la figure 1, l'angle entre l'axe du faisceau 14 et l'axe de propagation du jet 6c de nanoparticules est de 90° et, l'axe normal 17 à la surface cible 15 forme un angle de 45° par rapport à chacun de ces axes. Ceci permet le co-dépôt de la matrice et des nanoparticules.

Il est également possible d'effectuer un dépôt séquentiel avec le dispositif représenté sur la figure 1. Par exemple, pour effectuer un dépôt séquentiel de la matrice et des nanoparticules, il est possible de disposer l'axe normal 17 de la surface cible 15, avec les moyens de déplacement 19 de cette surface cible 15, séquentiellement, parallèlement à l'axe du faisceau 14 ou à l'axe du jet 6c de nanoparticules.

Un dépôt séquentiel permet, par exemple, d'élaborer des motifs de haute densité en nanoparticules en deux ou en trois dimensions sur la surface cible 15. Un dépôt séquentiel permet également d'élaborer des dépôts multicouches composés de différents matériaux, en particulier en ce qui concerne la nature des nanoparticules.

La chambre de synthèse 3 peut également comprendre un moyen de chauffage 20, avantageusement disposé en vis-à-vis de la face de la surface cible 15 sur laquelle la synthèse du matériau composite nanostructuré est réalisée.

En portant la surface cible 15 à des températures plus élevées que la température ambiante, on peut alors maîtriser la porosité et la structure aux échelles micrométriques et nanométriques du matériau composite nanostructuré finalement obtenu.

Le moyen de chauffage 20 de la surface cible 15 peut fonctionner par conduction. Dans ce cas, on positionne le moyen de chauffage 20, par exemple une résistance électrique, sur la face arrière du substrat 15, cette face arrière étant la face du substrat 15 opposée à la face sur laquelle le dépôt s'effectue.

En variante, le moyen de chauffage 20 peut fonctionner par rayonnement électromagnétique ou par bombardement électronique, comme cela est représenté sur la figure 1.

Dans le cas d'un chauffage par rayonnement électromagnétique, le moyen de chauffage 20 peut être un laser, impulsionnel ou continu, une lampe éventuellement équipée d'un dispositif de focalisation et/ou de filtration spectrale, ou toute autre source de rayonnement électromagnétique.

Un exemple de dépôt d'un matériau réalisé avec le dispositif de la figure 1 (lentille aérodynamique) est fourni ci-après :

- $N_g = 2,42E+19\, m^{-3}$ (ce qui correspond à une pression de 0,1 Pa dans la chambre de synthèse 3);
- $M_g = 6,64E\text{-}23$ g.mol$^{-1}$ (Argon);
- $n = n_p = 3266$;
- $M_p = 4,66E\text{-}23$ g.mol$^{-1}$ (Silicium)
- $r_p = 2,5$ mm soit $\sigma_p = 7,85E\text{-}17\ m^2$ (pas d'agglomérat) ;
- $V_g/V_p = 0,916$ ce qui donne

$$F_{ao}\left(\infty, \frac{V_g}{V_p}\right) = 1,55 \text{ par le tableau de la figure}$$

2 ; et ;
- $L = 0,2$ m.

ce qui donne une valeur de 0,3 environ pour la constante C.

L'exemple précédent est issu d'un essai réalisé pour des nanoparticules non agglomérées.

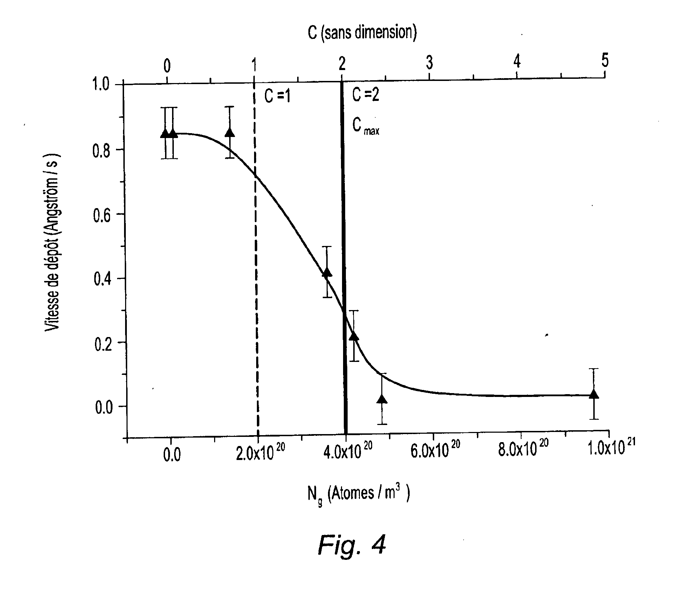

D'autres exemples expérimentaux réalisés avec le dispositif de la figure 1 sont fournis à l'appui de la figure 4, pour des nanoparticules agglomérées, dans les conditions suivantes:

- $N_g$ variable car plusieurs essais sont présentés sur la figure 4 ($N_g$ est représentatif de la pression régnant dans la chambre de synthèse 3);
- $M_g = 6,64E\text{-}23$ g.mol$^{-1}$ (Argon);
- $n_{pp} = 250$ (mesure TEM);
- $n = n_{pp} * n_p = 250*3266 = 816\ 500$
- $M_p = 4,66E\text{-}23$ g.mol$^{-1}$ (Silicium)
- $r_p = 2,5$ mm soit $\sigma_p = 7,85E\text{-}17\ m^2$ puis, $\sigma_a = 1,02E\text{-}14\ m^2$ (car aggloméré) ;
- $V_g/V_p = 1,2875$ ce qui donne

$$F_{ao}\left(\infty, \frac{V_g}{V_p}\right) = 1,35 \text{ par le tableau de la figure}$$

2 ; et ;
- $L = 0,2$ m.

La figure 4 représente 7 essais qui ont été réalisés dans les conditions précédentes, pour différentes valeurs de la pression dans la chambre de synthèse ($N_g$ ; en abscisses). En ordonnées, il est mentionné la vitesse de dépôt des nanoparticules sur la surface cible 15. Par ailleurs, pour aider la lecture, l'expression de la constante C est également fournie en abscisses, cette constante étant directement proportionnelle à la valeur de $N_g$.

Il convient de noter que la variable $N_g$ pourrait tout à fait être remplacée par la longueur L, compte tenu de l'expression de la constante C.

Un dépôt de bonne qualité peut être obtenu jusqu'à $C = C_{max} = 2$ ; ce qui correspond, dans le cas d'espèce, à une pression d'argon d'environ 1,65Pa.

Une variante 100' de réalisation du dispositif 100 de la figure 1 est représentée sur la figure 3.

Le dispositif 100' se distingue du dispositif 100 par le seul contenu de la chambre de synthèse 3'.

En effet, le système 4, 1, 5, 9 pour générer le jet de nanoparticules dans un gaz porteur n'est pas modifié. La description faite précédemment s'applique donc également au dispositif 100'.

Dans cette variante, la configuration de la chambre de synthèse 3' est réalisée pour effectuer un dépôt dit concentrique, lequel peut être un co-dépôt ou un dépôt séquentiel de la matrice et des nanoparticules.

Dans cette configuration, l'axe normal 17 à la surface cible 15 est confondu avec l'axe de propagation du jet de nanoparticules 6c.

Cette configuration peut inclure un ou plusieurs systèmes de dépôt 13a, 13b, qui peuvent être identiques.

Une version particulière de cette configuration comporte deux dispositifs de dépôt 13a, 13b de la matrice.

Comme représenté sur la figure 3, les axes de propagation des atomes ou molécules 14a, 14b générés par ces systèmes de dépôt 13a, 13b sont placés à des angles compris entre 0° et 90° par rapport à l'axe de propagation du jet de nanoparticules 6c.

Cette variante de réalisation présente un intérêt lorsque l'on souhaite augmenter la vitesse de synthèse du matériau composite nanostructuré. Elle permet également de déposer plusieurs matériaux de natures chimiques différentes pour la matrice, en même temps ou de manière séquentielle.

En variante (non représentée), on pourrait inclure également un ou plusieurs systèmes de dépôts de géométrie annulaire et percés en leurs centres pour laisser passer le jet supersonique de nanoparticules. Cette variante peut être particulièrement intéressante sur le plan industriel, car elle permet d'augmenter encore plus la vitesse de synthèse du matériau composite nanostructuré, en augmentant la vitesse de dépôt de la matrice.

La représentation de la figure 3 montre le dispositif en fonctionnement, lors d'un co-dépôt de la matrice et des nanoparticules sur la surface cible 15. Le moyen 5 utilisé est en l'occurrence une lentille aérodynamique divergente.

Un dépôt séquentiel pourrait être envisagé, en faisant fonctionner séquentiellement les systèmes de dépôt 13a, 13b de la matrice d'une part, et le système pour générer le jet supersonique de nanoparticules d'autre part.

Le dépôt, simple ou réactif, séquentiel ou simultané, de plusieurs matériaux constituant la matrice permet d'obtenir des profils chimiques complexes de la matrice suivant l'épaisseur de la couche déposée sur la surface cible 15.

En particulier, on peut alors synthétiser un matériau composite nanostructuré avec une matrice de composition chimique variable en fonction de l'épaisseur. Une application intéressante concernerait la fabrication de jonctions nanostructurées dans le domaine de la microélectronique, par exemple des jonctions de type p-n pour des diodes, transistors ou cellules photovoltaïques à base de silicium.

Avec les dispositifs 100, 100' décrits précédemment, il est alors possible de mettre en oeuvre un procédé de synthèse d'un matériau composite nanostructuré 16 comprenant des nanoparticules enrobées dans une matrice comprenant les étapes suivantes :

(a) déposer une matrice pour ledit matériau dans une chambre de synthèse 3, 3' dudit matériau, sur une surface cible 15;
(b) générer un jet de nanoparticules dans un gaz porteur avec un système 1, 4, 9, 5 comprenant une chambre de détente 1 munie d'un orifice de sortie 7 séparant la chambre de détente de la chambre de synthèse 3, 3' ;
(c) régler la distance L entre l'orifice de sortie 7 de la chambre de détente 1 et la surface cible 15 et/ou ajuster la pression du gaz présent dans la chambre de synthèse.

L'étape (a) peut être effectuée par pulvérisation cathodique classique, par dépôt physique en phase vapeur ou par dépôt chimique en phase vapeur, éventuellement assisté par plasma. En particulier, on peut utiliser un dépôt chimique en phase vapeur assisté par plasma, dit à basse « pression » comme défini précédemment.

On peut chauffer la surface cible 15 pour maîtriser la porosité et la structure aux échelles micrométriques et nanométriques du matériau composite nanostructuré finalement obtenu.

Enfin, et comme mentionné précédemment, on pourra déposer les nanoparticules et la matrice sur la surface cible 15 en même temps ou, au contraire, séquentiellement.

La distance L et/ou la pression sont ajustés de sorte que C est inférieur ou égale à deux, où les paramètres intervenant dans la constante C ont été définis précédemment.

La valeur de la constante C pourra être ajustée pour être inférieure ou égale à 1,9 ; 1,8 ; 1,7 ; 1,6 ; ou de préférence inférieure ou égale à 1,5, valeur en dessous de laquelle le dépôt est d'excellente qualité.

Typiquement, la pression dans la chambre de détente 1 est comprise entre 0,01Pa et 10Pa, de préférence entre 0,01Pa et 0,2Pa et la pression dans la chambre de synthèse 3, 3' est comprise entre 0,001Pa et 10Pa.

En particulier, la pression dans la chambre de détente 1 est avantageusement comprise entre 0,01Pa et 0,2Pa, pour les raisons déjà mentionnées précédemment. En particulier également, la pression régnant dans la chambre de synthèse 3 pourra être comprise entre 0,05Pa et 10Pa, avantageusement entre 0,1 Pa et 1 Pa. Ceci permet de mettre en oeuvre un système de dépôt classique, choisi parmi l'un de ceux décrits précédemment.

En pratique, un dépôt de bonne qualité peut être obtenu de différentes façons.On peut régler la distance L entre l'orifice de sortie 7 de la chambre de détente 1, 1' et la chambre de synthèse 3, 3'.

On peut également ajuster la pression dans la chambre de synthèse 3, 3' (et donc la quantité Ng) par l'introduction d'un gaz neutre tel que l'argon, l'azote ou un mélange de gaz neutres.

On peut encore introduire un ou plusieurs gaz précurseurs dans le cas où le dépôt du matériau de la matrice est réalisé par dépôt chimique en phase vapeur, éventuellement assisté par plasma (« PECVD » pour « Plasma Enhanced Chemical Vapor Deposition » selon la terminologie anglo-saxonne) ou par pulvérisation cathodique classique.

On pourrait également régler la température de la chambre de synthèse 3, 3' pour ajuster la pression qui y règne.

Les solutions consistant à régler la distance L entre l'orifice de sortie 7 de la chambre de détente 1, 1' et la chambre de synthèse 3, 3' et/ou à introduire un gaz supplémentaire dans cette chambre 3, 3' sont cependant les solutions les plus aisées à mettre en oeuvre.

En effet, les dispositifs 100, 100' représentés sur les figures 1 et 3 mettent en oeuvre un système de réglage de la distance L (par exemple le système 21, 22, 23), ainsi qu'un moyen 12 pour introduire un gaz supplémentaire dans la chambre de synthèse qui sont faciles à mettre en oeuvre.

De manière plus générale, l'invention concerne un procédé de synthèse d'un matériau composite nanostructuré 16 comprenant des nanoparticules enrobées dans une matrice comprenant les étapes suivantes :

(A) déposer une matrice pour ledit matériau dans une chambre de synthèse 3, 3' dudit matériau, sur une surface cible 15;
(B) générer un jet de nanoparticules dans un gaz porteur avec un système 1, 4, 9, 5 comprenant une chambre de détente 1 munie d'un orifice de sortie 7 séparant la chambre de détente 1 de la chambre de synthèse 3, 3' ;
(C) ajuster la constante C définie par

$$C = L . N_g . \frac{M_g}{n . M_p} . \sigma . F_{ao}\left(\infty, \frac{V_g}{V_p}\right)$$ à une valeur inférieure ou égale à deux, où les différents paramètres intervenants dans l'expression de cette constante C ont été définis précédemment.

Dans ce dernier procédé (étapes (A), (B) et (C)), on réglera avantageusement la distance L et/ou on ajustera la pression dans la chambre de synthèse 3, 3' et/ou on ajustera le facteur $F_{ao}\left(\infty, \frac{V_g}{V_p}\right)$ pour ajuster la constante C tel que décrit précédemment.
En effet, on peut aussi ajuster la valeur de la constante C en réglant la température de la chambre de synthèse 3,3'.
Ainsi on influence sur le facteur

$$F_{ao}\left(\infty, \frac{V_g}{V_p}\right).$$ Ceci peut par exemple s'effectuer en modifiant la température du gaz entraînant les nanoparticules avant la détente pour jouer sur la vitesse des particules $V_p$ par l'intermédiaire de la vitesse du gaz porteur.
Le dispositif selon l'invention est particulièrement prometteur. En effet, le contexte économique qui motive la réalisation de nouveaux matériaux composites nanostructurés est extrêmement vaste. Ceci est lié à la diversité des matériaux envisageables pour les nanoparticules et la matrice. Ainsi, le champ d'application de l'invention peut être très étendu dans ses applications.
Il peut par exemple s'agir du domaine actuellement très porteur de la production et du stockage de l'énergie, du stockage d'informations, du traitement de surface pour conférer de nouvelles propriétés aux supports (autonettoyant, autocicatrisant, résistant à l'abrasion...).
En particulier, une des applications envisagées avec le dispositif 100, 100' selon l'invention se situe dans le domaine de la conversion du rayonnement solaire en électricité.
Les cellules solaires photovoltaïques actuelles utilisent pour la plupart le silicium cristallin comme matériau de conversion. L'application visée consisterait en une cellule solaire tout silicium à haut rendement. On envisage pour cela une cellule dite tandem dans laquelle une jonction réalisée avec un matériau composite nanostructuré à base de cristaux de silicium est juxtaposée à une jonction monocristalline classique.
Pour limiter la thermalisation des porteurs générés par les photons énergétiques, le gap du matériau composite nanostructuré peut être ajusté à une valeur cible proche de 1,7eV en fonction de la taille des nanoparticules, en l'occurrence des nanocristaux. Le rendement théorique d'une telle cellule tandem a été déterminé comme étant proche de 42%, qu'il faut comparer au rendement de 24% d'une cellule silicium classique, obtenu en laboratoire. La jonction réalisée avec un matériau composite nanostructuré serait composée de nanoparticules de silicium cristallines de taille contrôlée enrobées dans une matrice de $SiO_2$, $Si_3N_4$ ou SiC.
D'autres applications utilisant d'autres matériaux pour les nanoparticules et pour la matrice, comme par exemple les céramiques ou le diamant, sont visées dans les domaines du renfort mécanique de surface par dépôts nanostructurés ou des matériaux auto-réparants, par exemple.
Les matériaux composites nanostructurés à matrice métallique sont utilisés dans l'industrie de l'automobile (Al / SiC), de la microélectronique (Al/AlN ou $Al_2O_3$), du magnétisme (Fe /MgO), de la catalyse (Fe / TiN), des matériaux de structure (acier ODS, Nb / Cu), de l'électrochimie (Ni / $TiO_2$).
Les matériaux composites nanostructurés à matrice céramique sont rencontrés dans les domaines de la catalyse ($TiO_2$ / Pt), des fibres optiques ($SiO_2$ / Co), des matériaux de structure ($Al_2O_3$ ou $Si_3N_4$ / SiC), des matériaux luminescents ($Al_2O_3$ / $NdAlO_3$), du magnétisme ($TiO_2$ / $Fe_2O_3$).

## Revendications

1. Procédé de synthèse d'un matériau composite nanostructuré (16) comprenant des nanoparticules enrobées dans une matrice, **caractérisé en ce qu'**il comprend les étapes suivantes :

(a) déposer une matrice pour ledit matériau dans une chambre de synthèse (3, 3') dudit matériau, sur une surface cible (15);
(b) générer un jet de nanoparticules dans un gaz porteur avec un système (1, 4, 9, 5) comprenant une chambre de détente (1) munie d'un orifice de sortie (7) séparant la chambre de détente (1) de la chambre de synthèse (3, 3') ;

(c) régler la distance L entre l'orifice de sortie (7) de la chambre de détente (1) et la surface cible (15) et/ou ajuster la pression du gaz présent dans la chambre de synthèse et/ou ajuster un facteur $F_{ao}\left(\infty, \frac{V_g}{V_p}\right)$ prenant en compte l'influence de la vitesse moyenne $V_g$ du gaz présent dans la chambre de synthèse (3,3') et l'influence de la vitesse moyenne Vp desdites nanoparticules dans le jet de nanoparticules dans un gaz porteur, de sorte que la constante C définie par

$$C = L. N_g. \frac{M_g}{n.M_p}. \sigma. F_{ao}\left(\infty, \frac{V_g}{V_p}\right)$$ ait une valeur inférieure ou égale à deux, mais non nulle, où :

$N_g$, la densité atomique ou moléculaire du gaz présent dans la chambre de synthèse (3, 3').

$M_g$, la masse molaire de ce gaz,

n, le nombre moyen d'atomes ou de molécules par nanoparticule, Mp la masse molaire desdits atomes ou molécules composant les nanoparticules, et

σ, la section efficace géométrique moyenne desdites nanoparticules, lesquelles sont susceptibles de se présenter sous une forme agglomérée ou non.

2. Procédé selon la revendication 1, dans lequel on ajuste la pression dans la chambre de synthèse (3, 3') par l'introduction d'un gaz supplémentaire dans cette chambre de synthèse (3, 3').

3. Procédé selon l'une des revendications précédentes, dans lequel on ajuste la pression dans la chambre de synthèse (3, 3') par l'introduction d'un gaz neutre ou d'un mélange de gaz neutres.

4. Procédé selon l'une des revendications précédentes, dans lequel on introduit un ou plusieurs gaz précurseurs dans la chambre de synthèse (3, 3'),

5. Procédé selon l'une des revendications précédentes, dans lequel la pression dans la chambre de détente (1) est comprise entre 0,01 Pa et 10Pa.

6. Procédé selon l'une des revendications précédentes, dans lequel la pression dans la chambre de synthèse (3, 3') est comprise entre 0,001 Pa et 10Pa, de préférence entre 0,1 Pa et 1Pa.

7. Procédé selon l'une des revendications précédentes, dans lequel l'étape (a) est effectuée par pulvérisation cathodique, par dépôt physique en phase vapeur ou par dépôt chimique en phase vapeur, éventuellement assisté par plasma.

8. Procédé selon l'une des revendications précédentes, dans lequel on chauffe la surface cible (15).

9. Procédé selon l'une des revendications précédentes, dans lequel on dépose les nanoparticules et la matrice sur la surface cible (15) en même temps ou séquentiellement.

10. Procédé selon l'une des revendications précédentes, dans lequel l'étape (c) consiste à ajuster la constante C à une valeur inférieure ou égale à 1,5.

11. Dispositif (100, 100') pour la mise en oeuvre d'un procédé de synthèse d'un matériau composite nanostructuré (16) comprenant des nanoparticules enrobées dans une matrice selon l'une des revendications précédentes, **caractérisé en ce qu'**il comprend :

- une chambre de synthèse (3, 3') dudit matériau comportant un système (13, 13a, 13b) de dépôt de la matrice sur une surface cible (15) ;
- un système (1, 4, 5, 9) pour générer un jet de nanoparticules dans un gaz porteur comportant une chambre de détente (1) munie d'un orifice de sortie (7) des nanoparticules, séparant la chambre de détente (1) de la chambre de synthèse (3, 3') ;
- des moyens (21, 22, 23) pour régler la distance L entre l'orifice de sortie (7) de la chambre de détente et la surface cible (15).

12. Dispositif selon la revendication précédente, dans lequel la chambre de synthèse (3, 3') comprend au moins un dispositif (12) pour introduire un gaz, tel qu'un gaz neutre, dans cette chambre (3, 3').

13. Dispositif selon l'une des revendications 11 ou 12, dans lequel le système (1, 4, 5, 9) pour générer un jet moléculaire de nanoparticules dans un gaz porteur comprend également:

- un réservoir (4) comportant un mélange de nanoparticules et d'un gaz porteur ;
- une tuyère ou une lentille aérodynamique (5) située entre le réservoir (4) et la chambre de détente (1) ;
- un moyen de pompage (9) du fluide présent dans la chambre de détente (1).

14. Dispositif selon la revendication précédente, dans lequel la distance entre la tuyère ou la lentille aérodynamique (5) d'une part, et l'orifice de sortie (7) de la chambre de détente (1) d'autre part, est comprise entre 1mm et 60mm, de préférence entre 5mm et 30mm.

15. Dispositif selon l'une des revendications 13 ou 14, dans lequel la distance entre la tuyère ou la lentille aérodynamique (5) d'une part, et l'orifice de sortie (7) de la chambre de détente (1) d'autre part, est réglable.

16. Dispositif selon l'une des revendications 11 à 15, dans lequel l'orifice de sortie (7) de la chambre de détente (1) est un diaphragme destiné à limiter l'angle solide du jet de gaz porteur entraînant les nanoparticules, ce diaphragme étant par exemple un écorceur circulaire de section conique et dont le diamètre situé à la pointe du cône est compris entre 0,1mm et 2mm.

**Patentansprüche**

1. Verfahren zur Synthese eines nanostrukturierten Verbundmaterials (16), welches in einer Matrix eingehüllte Nanopartikel umfasst, **dadurch gekennzeichnet, dass** es die folgenden Schritte umfasst:

   (a) Deponieren einer Matrix für das Material in einer Synthesekammer (3, 3') für das Material, auf einer Zielfläche (15);
   (b) Erzeugen eines Strahls von Nanopartikeln in einem Trägergas mit einem System (1, 2, 9, 5), welches eine Expansionskammer (1) aufweist, die mit einer Ausgangsöffnung (7) versehen ist, welche die Expansionskammer (1) von der Synthesekammer (3, 3') separiert;
   (c) Regeln des Abstands L zwischen der Ausgangsöffnung (7) der Expansionskammer (1) und der Zielfläche (15) und/oder Anpassen des Drucks des in der Synthesekammer vorhandenen Gases und/oder Anpassen eines Faktors

   $$F_{ao}\left(\infty, \frac{v_g}{v_p}\right) ,$$ welcher den Einfluss der mittleren Geschwindigkeit $v_g$ des in der Synthesekammer (3, 3') vorhandenen Gases und den Einfluss der mittleren Geschwindigkeit ($V_p$) der Nanopartikel in dem Strahl von Nanopartikeln in einem Trägergas berücksichtigt, sodass die Konstante C, welche definiert ist durch

   $$C = L . N_g . \frac{M_g}{n . M_p} . \sigma . F_{ao}\left(\infty, \frac{v_g}{v_p}\right)$$ einen

   Wert von kleiner oder gleich zwei, aber nicht nulll hat, wobei:

   $N_g$ die atomare oder molekulare Dichte des in der Synthesekammer (3, 3') vorhandenen Gases ist,
   $M_g$ die Molmasse dieses Gases ist,
   n die mittlere Anzahl von Atomen oder Molekülen pro Nanopartikel ist, $M_p$ die molare Masse der die Nanopartikel bildenden Atome oder Moleküle ist, und

   σ der mittlere effektive Querschnitt der Nanopartikel ist, welche in einer agglomerierten oder nicht-agglomerierten Form auftreten können.

2. Verfahren nach Anspruch 1, wobei der Druck in der Synthesekammer (3, 3') durch Einführen eines Zusatzgases in diese Synthesekammer (3, 3') angepasst wird.

3. Verfahren nach einem der vorhergehenden Ansprüche, wobei der Druck in der Synthesekammer (3, 3') durch Einführen eines neutralen Gases oder einer Mischung von neutralen Gasen angepasst wird.

4. Verfahren nach einem der vorhergehenden Ansprüche, wobei ein oder mehrere Vorläufergase in die Synthesekammer (3, 3') eingeführt werden.

5. Verfahren nach einem der vorhergehenden Ansprüche, wobei der Druck in der Expansionskammer (1) zwischen 0,01 Pa und 10 Pa enthalten ist.

6. Verfahren nach einem der vorhergehenden Ansprüche, wobei der Druck in der Synthesekammer (3, 3') zwischen 0,001 Pa und 10 Pa, bevorzugt zwischen 0,1 Pa und 1 Pa enthalten ist.

7. Verfahren nach einem der vorhergehenden Ansprüche, wobei der Schritt (a) bewerkstelligt wird durch Kathodenzerstäubung, durch physikalische Dampfphasendeponierung oder durch chemische Dampfphasendeponierung, unter Umständen durch Plasma unterstützt.

8. Verfahren nach einem der vorhergehenden Ansprüche, wobei die Zielfläche (15) geheizt wird.

9. Verfahren nach einem der vorhergehenden Ansprüche, wobei die Nanopartikel und die Matrix auf der Zielfläche (15) gleichzeitig oder nacheinander deponiert werden.

10. Verfahren nach einem der vorhergehenden Ansprüche, wobei der Schritt (c) darin besteht, dass die Konstante C auf einen Wert von kleiner oder gleich 1,5 angepasst wird.

11. Vorrichtung (100, 100') zum Einsatz eines Verfahrens zur Synthese eines nanostrukturierten Verbundmaterials (16), welches in einer Matrix eingehüllte Nanopartikel umfasst, nach einem der vorhergehenden Ansprüche, **dadurch gekennzeichnet, dass** sie umfasst:

   - eine Synthesekammer (3, 3') für das Material, welche ein System (13, 13a, 13b) zur Deponierung der Matrix auf einer Zielfläche (15) umfasst;

- ein System (1, 4, 5, 9), um einen Strahl von Nanopartikeln in einem Trägergas zu erzeugen, welches eine Expansionkammer (1) umfasst, welche mit einer Ausgangsöffnung (7) für die Nanopartikel versehen ist, welche die Expansionskammer (1) von der Synthesekammer (3, 3') separiert;
- Mittel (21, 22, 23), um den Abstand L zwischen der Ausgangsöffnung (7) der Expansionskammer und der Zielfläche (15) zu regeln.

12. Vorrichtung nach dem vorhergehenden Anspruch, wobei die Synthesekammer (3, 3') wenigstens eine Vorrichtung (12) zum Einführen eines Gases, wie zum Beispiel eines neutralen Gases, in diese Kammer (3, 3') umfasst.

13. Vorrichtung nach einem der Ansprüche 11 oder 12, wobei das System (1, 4, 5, 9) zum Erzeugen eines molekularen Strahls von Nanopartikeln in einem Trägergas außerdem umfasst:

- ein Reservoir (4), welches eine Mischung von Nanopartikeln und einem Trägergas enthält;
- eine Düse oder eine aerodynamische Linse (5), welche sich zwischen dem Reservoir (4) und der Expansionskammer (1) befindet;
- ein Mittel zum Pumpen (9) des in der Expansionskammer (1) vorhandenen Fluids.

14. Vorrichtung nach dem vorhergehenden Anspruch, wobei der Abstand zwischen einerseits der Düse oder der aerodynamischen Linse (5) und andererseits der Ausgangsöffnung (7) der Expansionskammer (1) zwischen 1 mm und 60 mm, bevorzugt zwischen 5 mm und 30 mm enthalten ist.

15. Vorrichtung nach einem der Ansprüche 13 oder 14, wobei der Abstand zwischen einerseits der Düse oder der aerodynamischen Linse (5) und andererseits der Ausgangsöffnung (7) der Expansionskammer (1) regelbar ist.

16. Vorrichtung nach einem der Ansprüche 11 bis 15, wobei die Ausgangsöffnung (7) der Expansionskammer (1) eine Membran ist, welche dazu bestimmt ist, den Raumwinkel des Strahls des die Nanopartikeln befördernden Trägergases zu begrenzen, wobei diese Membran beispielsweise ein Kreisdivertor mit konischem Querschnitt ist, dessen Durchmesser an der Spitze des Konus zwischen 0,1 mm und 2 mm enthalten ist.

## Claims

1. Process for synthesizing a nanostructured composite material (16) comprising nanoparticles coated in a matrix, **characterized in that** it comprises the following steps:

(a) depositing a matrix for said material in a chamber (3, 3') for synthesizing said material, on a target surface (15);
(b) generating a jet of nanoparticles in a carrier gas with a system (1, 4, 9, 5) comprising an expansion chamber (1) equipped with an outlet orifice (7) separating the expansion chamber (1) from the synthesis chamber (3, 3');
(c) adjusting the distance L between the outlet orifice (7) of the expansion chamber (1) and the target surface (15) and/or adjusting the pressure of the gas present in the synthesis chamber and/or adjusting a factor

$$F_{ao}\left(\infty, \frac{V_g}{V_p}\right)$$ that takes into account the influence of the mean velocity Vg of the gas present in the synthesis chamber (3,3') and the influence of the mean velocity $V_p$ of said nanoparticules in the jet of nanoparticles, in a carrier gas, so that the constant C defined by

$$C = L.N_g . \frac{M_g}{n.M_p}.\sigma . F_{ao}\left(\infty, \frac{V_g}{V_p}\right)$$ has a value less than or equal to two, but not zero, where:

$N_g$ is the atomic or molecular density of the gas present in the synthesis chamber (3, 3'),
$M_g$ is the molar mass of this gas,
n is the mean number of atoms or molecules per nanoparticle,
$M_p$ is the molar mass of said atoms or molecules making up the nanoparticles, and σ is the mean geometric effective cross section of said nanoparticles, which are capable of being in an agglomerated or unagglomerated form.

2. Process according to Claim 1, in which the pressure in the synthesis chamber (3, 3') is adjusted by introducing a supplementary gas into this synthesis chamber (3, 3').

3. Process according to either of the preceding claims, in which the pressure in the synthesis chamber (3, 3') is adjusted by introducing an inert gas or a mixture of inert gases.

4. Process according to one of the preceding claims, in which one or more precursor gases are introduced into the synthesis chamber (3, 3').

5. Process according to one of the preceding claims, in which the pressure in the expansion chamber (1) is between 0.01 Pa and 10 Pa.

6. Process according to one of the preceding claims, in which the pressure in the synthesis chamber (3, 3') is between 0.001 Pa and 10 Pa, preferably between 0.1 Pa and 1 Pa.

7. Process according to one of the preceding claims, in which step (a) is carried out by sputtering, by physical vapor deposition or by chemical vapor deposition, optionally plasma-enhanced.

8. Process according to one of the preceding claims, in which the target surface (15) is heated.

9. Process according to one of the preceding claims, in which the nanoparticles and the matrix are deposited on the target surface (15) at the same time or sequentially.

10. Process according to one of the preceding claims, in which step (c) consists in adjusting the constant C to a value less than or equal to 1.5.

11. Device (100, 100') for implementing a process for synthesizing a nanostructured composite material (16) comprising nanoparticles coated in a matrix according to one of the preceding claims, **characterized in that** it comprises:

    - a chamber (3, 3') for synthesizing said material comprising a system (13, 13a, 13b) for depositing the matrix on a target surface (15);
    - a system (1, 4, 5, 9) for generating a jet of nanoparticles in a carrier gas comprising an expansion chamber (1) equipped with an outlet orifice (7) for the nanoparticles, separating the expansion chamber (1) from the synthesis chamber (3, 3') ;
    - means (21, 22, 23) for adjusting the distance L between the outlet orifice (7) of the expansion chamber and the target surface (15).

12. Device according to the preceding claim, in which the synthesis chamber (3, 3') comprises at least one device (12) for introducing a gas, such as an inert gas, into this chamber (3, 3').

13. Device according to either of Claims 11 and 12, in which the system (1, 4, 5, 9) for generating a molecular jet of nanoparticles in a carrier gas also comprises:

    - a tank (4) comprising a mixture of nanoparticles and a carrier gas;
    - a nozzle or an aerodynamic lens (5) located between the tank (4) and the expansion chamber (1);

    - a means (9) for pumping the fluid present in the expansion chamber (1).

14. Device according to the preceding claim, in which the distance between the nozzle or the aerodynamic lens (5) on the one hand, and the outlet orifice (7) of the expansion chamber (1) on the other hand, is between 1 mm and 60 mm, preferably between 5 mm and 30 mm.

15. Device according to either of Claims 13 and 14, in which the distance between the nozzle or the aerodynamic lens (5) on the one hand, and the outlet orifice (7) of the expansion chamber (1) on the other hand, is adjustable.

16. Device according to one of Claims 11 to 15, in which the outlet orifice (7) of the expansion chamber (1) is a diaphragm intended to limit the solid angle of the jet of carrier gas conveying the nanoparticles, this diaphragm being for example a circular skimmer of conical cross section and the diameter of which, located at the tip of the cone, is between 0.1 mm and 2 mm.

Fig. 1

Fig. 3

| $\frac{Vg}{Vp}$ | $Fao\left(\infty, \frac{Vg}{Vp}\right)$ | $\frac{Vg}{Vp}$ | $Fao\left(\infty, \frac{Vg}{Vp}\right)$ |
|---|---|---|---|
| 0,00 | $\infty$ | 2,00 | 1,1249 |
| 0,05 | 22,586 | 2,10 | 1,1133 |
| 0,10 | 11,321 | 2,20 | 1,1033 |
| 0,15 | 7,5788 | 2,30 | 1,0945 |
| 0,20 | 5,7168 | 2,40 | 1,0868 |
| 0,25 | 4,6070 | 2,50 | 1,0800 |
| 0,30 | 3,8731 | 2,60 | 1,0740 |
| 0,35 | 3,3540 | 2,70 | 1,0686 |
| 0,40 | 2,9690 | 2,80 | 1,0638 |
| 0,45 | 2,6734 | 2,90 | 1,0595 |
| 0,50 | 2,4403 | 3,00 | 1,0556 |
| 0,55 | 2,2525 | 3,20 | 1,0488 |
| 0,60 | 2,0986 | 3,40 | 1,0433 |
| 0,65 | 1,9707 | 3,60 | 1,0386 |
| 0,70 | 1,8632 | 3,80 | 1,0346 |
| 0,75 | 1,7719 | 4,00 | 1,0312 |
| 0,80 | 1,6937 | 4,20 | 1,0283 |
| 0,85 | 1,6263 | 4,40 | 1,0258 |
| 0,90 | 1,5677 | 4,60 | 1,0236 |
| 0,95 | 1,5165 | 4,80 | 1,0217 |
| 1,00 | 1,4716 | 5,00 | 1,0200 |
| 1,10 | 1,3969 | 5,20 | 1,0185 |
| 1,20 | 1,3378 | 5,40 | 1,0171 |
| 1,30 | 1,2904 | 5,60 | 1,0159 |
| 1,40 | 1,2520 | 5,80 | 1,0149 |
| 1,50 | 1,2204 | 6,00 | 1,0139 |
| 1,60 | 1,1943 | 6,50 | 1,0118 |
| 1,70 | 1,1724 | 7,00 | 1,0102 |
| 1,80 | 1,1540 | 7,50 | 1,0089 |
| 1,90 | 1,1383 | 8,00 | 1,0078 |
| | | 8,50 | 1,0069 |
| | | 9,00 | 1,0062 |
| | | 9,50 | 1,0055 |
| | | 10,00 | 1,0050 |
| | | $\infty$ | 1,0000 |

*Fig. 2*

*Fig. 4*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0155474 A1

**Littérature non-brevet citée dans la description**

- **D. L. PENG.** Ferromagnetic, Transparent and Conducting ITO-Fe-Cluster Composite Films. *IEEE Transactions on Magnetics,* Octobre 2005, vol. 41 (10), 3406-3408
- **KOLIU.** Fractal and Projected Structure Properties of Soot Aggregates. *Combustion and Flame,* 1995, vol. 100, 621-633
- **BERKLING.** Effektive Stopquerschnitte bei Streuversuchen. *Zeitschrift für Physik,* 1966, vol. 166, 406-428
- **CUVELLIER.** A simple method to determine the mean cluster size in a molecular beam. *Z. Phys. D - Atoms, Molecules and Clusters,* 1991, vol. 21, 265-269